Europäisches Patentamt

European Patent Office

Office européen des brevets

(11) Veröffentlichungsnummer: **0 381 046**
**A2**

## (12) EUROPÄISCHE PATENTANMELDUNG

(21) Anmeldenummer: 90101462.1

(22) Anmeldetag: 25.01.90

(51) Int. Cl.5: **C23C 16/30, H01L 49/02**

(30) Priorität: 30.01.89 DE 3902628

(43) Veröffentlichungstag der Anmeldung:
08.08.90 Patentblatt 90/32

(84) Benannte Vertragsstaaten:
AT BE CH DE DK ES FR GB GR IT LI LU NL SE

(71) Anmelder: HAUNI ELEKTRONIK GMBH
Kampchaussee 8-32
D-2050 Hamburg 80(DE)

(72) Erfinder: Fischer, Helmut, Dipl.-Ing.
Haakestrasse 33
D-2100 Hamburg 90(DE)
Erfinder: Müller, Jörg, Dr.
Malsener Heide 9
D-2110 Buchholz(DE)

(54) **Dünnschichtmaterial für Sensoren oder Aktuatoren und Verfahren zu deren Herstellung.**

(57) Beschrieben wird ein Dünnschichtmaterial für Sensoren und Aktuatoren auf Siliziumbasis sowie ein Verfahren zum Herstellen eines solchen Dünnschichtmaterials.

Das Material besteht aus Siliziumoxidnitrid, das gemäß dem Verfahren auf ein geeignetes Trägermaterial, vorzugsweise Silizium, aufgebracht wird, wonach das Trägermaterial in bestimmten Bereichen entfernt wird.

Fig. 5

EP 0 381 046 A2

## Dünnschichtmaterial für Sensoren oder Aktuatoren und Verfahren zu deren Herstellung

Die Erfindung betrifft ein Dünnschichtmaterial für Sensoren oder Aktuatoren auf Siliziumbasis.

Die Erfindung betrifft außerdem ein Verfahren zum Herstellen von Dünnschichtmaterial für Sensoren oder Aktuatoren auf Siliziumbasis.

Es ist bekannt, Sensoren zum Umwandeln mechanischer Größen (Kräfte, Drücke, Beschleunigungen) in elektrische Größen sowie Aktuatoren zum Umwandeln elektrischer Größen in mechanische Kräfte, Drücke oder Beschleunigungen auf Siliziumbasis herzustellen. Es wird hierzu beispielsweise zunächst eine Schicht p-dotiertes Silizium auf ein n-dotiertes Trägermaterial durch Diffusion bei hohen Temperaturen, durch Ionenimplantation oder, für eine relativ dicke Schicht, durch epitaktisches Aufwachsen bei gleichzeitiger Dotierung aufgebracht. Die p-Dotierung dient als Ätzstopp für die Ätzlösung (z. B. Kalilauge oder eine Ethylendiamin-Brenzkatechin-Wasser-Lösung), durch die das Trägermaterial in bestimmten Bereichen weggeätzt wird. In der dünnen p-dotierten Schicht wird im Bereich der maximalen Dehnung ein n-dotierter Widerstand erzeugt, was bei starker p-Dotierung, wie sie als Ätzstopp erforderlich ist, technisch sehr schwierig ist. Als Ausweg kann nur die an das Trägermaterial angrenzende Siliziumschicht stark dotiert werden (Ätzstopp), während die Oberfläche schwächer p-dotiert wird, um dort den n-dotierten Widerstand leichter einbringen zu können. Die n-dotierten Widerstände werden bei Verformung der freiliegenden p-dotierten Dünnschicht ebenfalls verformt und verändern dabei sowohl ihren elektrischen Widerstand als auch ihre Halbleitereigenschaften, was z. B. in Brückenschaltungen erfaßt und in elektrische Signale umgesetzt werden kann, so daß man daraus auf die auslösenden mechanischen Größen schließen kann. In beiden Fällen weisen Sensoren mit derart hergestellten Dünnschichten und Leiterbahnen den Nachteil auf, daß die Temperaturdrift relativ hoch ist, daß der Meßbereich nur bis ca. 200 $^\circ$C verläuft und daß die Widerstandswerte in einem relativ großen Bereich streuen. Bei der Herstellung der Dünnschichten gemäß dem Stand der Technik wird wegen der p-Dotierung das Siliziumgitter gestört, so daß die Schichten nicht mehr spannungsfrei sind und Germanium zugegeben werden muß. Anlagen, mit denen die hohe p-Dotierung für den Ätzstopp hergestellt werden kann, können anschließend nicht mehr für Standardhalbleiterprozesse eingesetzt werden. Wegen der relativ geringen Stückzahlen von Halbleitern im Bereich der Sensorik ist eine derartige Anlage wegen schlechter Ausnutzung nicht wirtschaftlich betreibbar.

Die der Erfindung zugrundeliegende Aufgabe besteht in einem Dünnschichtmaterial für Sensoren und Aktuatoren, das das Aufbringen von Leiterbahnen mit geringer Tempeaturdrift und großem Meßbereich erlaubt, wobei die fertigungsbedingte Streuung der Widerstandswerte der aufgebrachten Leiterbahnen klein ist und die Dünnschichten nicht nur in widerstandsabhängigen, sondern auch in kapazitiven Meßanordnungen Verwendung finden können. Außerdem soll die Herstellung durch wenig aufwendige Standardhalbleiterprozesse erfolgen können.

Gemäß der Erfindung ist das Dünnschichtmaterial Siliziumoxidnitrid.

Weiterbildungen und weitere Ausgestaltungen des Dünnschichtmaterials gemäß der Erfindung sind den Unteransprüchen zu entnehmen.

Ein Verfahren, das sich zum Herstellen der eingangs erwähnten Dünnschicht besonders eignet, besteht gemäß der Erfindung darin, daß eine Siliziumoxidnitridschicht auf eine Trägermaterialschicht aufgebracht wird und daß danach das Trägermaterial in bestimmten Bereichen entfernt wird. Eine besonders vorteilhafte Herstellung durch Abscheiden von Silizium, Stickstoff und Sauerstoff auf geeignetes Trägermaterial, z. B. Silizium, kann gemäß der Erfindung in üblichen LPCVD-Anlagen oder PECVD-Anlagen vorgenommen werden, in denen Standardprozesse für die Halbleiterfertigung durchgeführt werden können, weil aufwendige Dotierungsaufgaben wie bei der Herstellung von Dünnschichten nach dem Stand der Technik entfallen.

Die zum Aufbau einer Siliziumoxidnitridschicht erforderlichen Bestandteile Silizium, Stickstoff und Sauerstoff können gemäß einer vorteilhaften Weiterbildung der Erfindung aus erhitzten oder plasmaaktivierten Gasen, z. B. Dichlorsilan, Silan oder Tetraethylorthosilikat, Ammoniak und Sauerstoff auf ein Trägermaterial, z. B. Silizium, abgeschieden werden. Ein besonders wichtiges Problem bei der Herstellung von Siliziumoxidnitridschichten besteht darin, daß eine derartige Schicht so aufgebaut wird, daß sie das gleiche Wärmeausdehnungsverhalten zeigt wie die Trägermaterialschicht, also zumindest annähernd den gleichen Wärmeausdehnungskoeffizienten aufweist, damit der Temperaturunterschied zwischen Herstellungstemperatur und Anwendungstemperatur in den Schichten keine schädlichen Spannung entstehen läßt. Gemäß einer wichtigen Ausgestaltung der Erfindung, die selbständigen erfinderischen Rang hat, wird beim Aufbau der Schicht das Mengenverhältnis der Bestandteile Siliziumoxid ($SiO_2$) und Siliziumnitrid ($Si_3N_4$) so gesteuert, daß der Wärmekoeffizient der Siliziumoxidnitridschicht zumindest annähernd übereinstimmt mit dem Wärmeausdehnungskoeffizienten der Trägermaterial schicht, z. B. des Siliziums. Die Steuerung des Mengenverhältnisses läßt sich vorteilhaft in Abhängigkeit von dem optischen Brechungsindex n der Siliziumoxidnitridschicht steuern, der ein Maß ist für das Mengenverhältnis. Der Brechungsindex kann mit Laserlicht (Ellipsometer) während des Schichtaufbaues erfaßt werden. Bei Abweichung des Brechungsindexes von dem gewünschten Brechungsindex n kann dann das Mengenverhältnis der Gase, aus dem Silizium, Stickstoff und Sauerstoff abgeschieden wird, im Sinne einer Konstanthaltung des Brechungsindexes der Schicht verändert werden. Bei zumindest annähernd gleichem Wärmeausdehnungskoeffizienten von Siliziumoxidnitridschicht und Trägermaterialschicht können bei Temperaturschwankungen keine oder nur unschädliche Spannungen entstehen.

Das Problem der Spannungsvermeidung in der fertigen Siliziumoxidnitridschicht, das auch das Problem der Erzeugung einer gewünschten Anfangsspannung sein kann (z.B. in Membranen aus Siliziumoxidnitrid), kann allgemein durch eine Steuerung des Mengenerhältnisses der Bestandteile der Siliziumoxidnitridschicht (Siliziumoxid und Siliziumnitrid) gelöst werden.

Weitere Ausgestaltungen des Verfahrens lassen sich den untergeordneten Verfahrensansprüchen entnehmen.

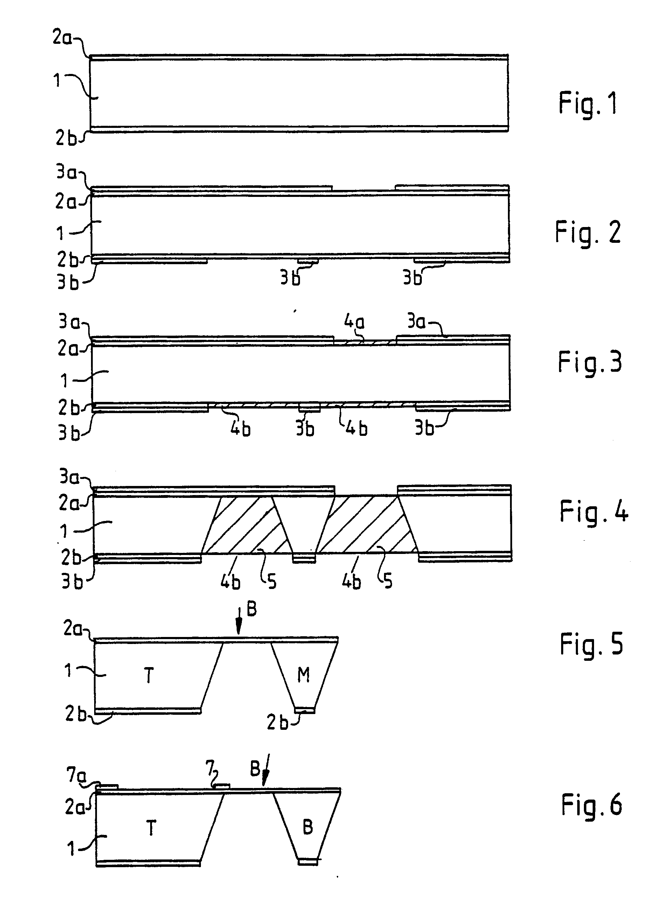

Die Erfindung wird anhand der Zeichnung (Figuren 1 bis 9) beispielsweise näher erläutert.

Figur 1 zeigt eine Trägermaterialschicht 1 aus reinem Silizium, auf die zwei dünne Schichten 2a und 2b aus Siliziumoxidnitrid aufgebracht werden. Siliziumoxidnitrid (in der älteren Schreibweise auch als Siliziumoxynitrid bezeichnet) besteht aus einer Mischung von Siliziumoxid ($SiO_2$ und Siliziumnitrid ($Si_3N_4$).

Die Herstellung der Schichten 2a, 2b kann in einer sogenannten LPCVD-Anlage erfolgen. Die vorstehenden Buchstaben stehen für Low Pressure Chemical Vapor Deposition. In der LPCVD-Anlage wird auf die sich in einem auf ca. 900 $^\circ$C erhitzten Quarzrohr befindliche Siliziumschicht 1 bei einem Druck von ca. $3 \cdot 10^1$ Pascal aus den vorbeigeförderten Gasen Silizium, Stickstoff und Sauerstoff abgeschieden. Silizium läßt sich aus gasförmigem Silan ($Si_nH_{2n+2}$, z. B. $SiH_4$), aus Dichlorsilan ($SiH_2Cl_2$) oder Tetraethylorthosilikat abscheiden, wobei $SiH_2Cl_2$ mit ca. 20 ml/min vorbeigeführt wird; Stickstoff läßt sich aus Ammoniak ($NH_3$), das z. B. mit 300 ml/min vorbeigeführt wird, abscheiden; Sauerstoff läßt sich aus Sauerstoffgas ($O_2$) abscheiden, das z. B. mit 10 ml/min vorbeigeführt wird. Unter den beschriebenen Bedingungen beträgt die Aufwachsrate der Siliziumoxidnitridschicht ca. 15 bis 18 nm/min. Anstelle der Trägermaterialschicht 1 aus reinem Silizium kann auch eine andere geeignete Substanz als Trägermaterial verwendet werden.

Eine Herstellung der Schichten 2a, 2b kann auch in sogenannten PECVD-Anlagen erfolgen, wobei die Buchstaben für Plasma Enhancement Chemical Vapor Deposition stehen. In einer derartigen Anlage wird die Erhitzung des Gases durch die Bildung eines Plasmas ersetzt.

Einzelheiten von LPCVD-Anlagen und von PECVD-Anlagen sind der Broschüre "Technologietrends in der Sensorik", VDI/VDE Technologiezentrum Informationstechnik GmbH, 1988, auf den Seiten 177 bis 180 zu entnehmen.

Durch das Mengenverhältnis der Silizium, Stickstoff und Sauerstoff abgebenden Gase kann das Mischungsverhältnis der Bestandteile Siliziumoxid und Siliziumnitrid in den Schichten 2a, 2b beeinflußt werden. Wird Siliziumoxid allein oder überwiegend abgeschieden, so stehen die Schichten 2a, 2b unter Druckspannung, wird Siliziumnitrid allein oder überwiegend abgeschieden, so stehen die Schichten 2a, 2b unter Zugspannung. Beide Spannungsarten sind für die Verwendung der Siliziumoxidnitridschcht als Biegebalken oder Membran nachteilig, zumindest, wenn sie bestimmte Grenzwerte übersteigen. Wenn der Wunsch besteht, daß die Schichten 2a, 2b ein Mischungsverhältnis von Siliziumoxid und Siliziumnitrid haben, bei dem zumindest annähernd Spannungsfreiheit herrscht, so liegt der optische Brechungsindex n der Schichten zwischen 1,6 und 1,7 (für Silizium als Trägermaterial), z. B. bei 1,65. Der Brechungsindex von Siliziumoxid allein beträgt 1,4 von Siliziumnitrid allein 2,0. Durch Messung des Brechungsindexes der Schichten 2a, 2b während ihrer Bildung, z. B. mittels Laserstrahlen in einem sogenannten Ellipsometer, kann durch Steuerung der Bestandteile der Gasmischung, aus der Silizium, Sauerstoff und Stickstoff abgeschieden werden, ein bestimmter Brechungsindex (z. B. zwischen 1,6 und 1,7) und damit das gewünschte Mengenverhältnis von Siliziumoxid und Siliziumnitrid eingehalten werden. Für Schichten 2a, 2b, die Membrane von Sensoren bilden sollen, kann eine leicht resultierende Zugspannung erwünscht sein. Auch für solche Schichten lassen sich durch Messung des Brechungsindexes und Steuerung der Gasanteile derart herstellen, daß in der fertigen Siliziumoxidnitridschicht eine Vorspannung besteht.

Durch Einstellung des Mischungsverhältnisses (z. B. über den Brechungsindex n) der Bestandteile Siliziumoxid (Wärmeausdehnungskoeffizient $\alpha = 0,5 \times 10^{-6}$ [$^\circ C^{-1}$] ) und Siliziumnitrid (Wäremausdehnungskoeffizient $= 2,8 \times 10^{-6}$ [$^\circ C^{-1}$] ) kann das Wärmeausdehnungsverhalten der Siliziumoxidnitridschicht demjenigen der Trägerschicht (Silizium hat z. B. ein $\alpha$ $2,6 \times 10^{-6}$ [$^\circ C^{-1}$] ) angepaßt werden, was große mechanische Stabilitätsvorteile bietet, wenn der mit der erfindungsgemäß hergestellten Schicht ausgerüstete Sensor oder Aktuator größeren Temperaturschwankungen ausgesetzt ist, weil ausdehnungsbedingte mechanische Spannungen nicht oder nur in geringem Maß auftreten.

Auf die beschriebene Weise sind somit zwei Schichten 2a, 2b von Siliziumoxidnitrid auf der Trägermaterialschicht (z. B. Silizium) aufgebracht worden (Figur 1), wobei die geforderten Eigenschaften bereits bei der Bildung durch Einstellung des Mischungsverhältnisses der zugeführten Gase, vorteilhaft in Abhängigkeit von der Messung des Brechungsindexes n der Siliziumoxidnitridschicht, festgelegt worden sind. Die Schichtdicke liegt im allgemeinen im My-Bereich, z. B. bei 2 My.

Nunmehr muß die Siliziumoxidnitridschicht stellenweise freigelegt werden, damit sie einen Biegebalken oder eine Membran in einem Sensor zur Erfassung von Kräften, Drücken oder Beschleunigungen bilden oder in einem Aktuator zum Erzeugen von mechanischen Kräften eingesetzt werden kann. Hierzu werden die Schichten 2a, 2b in den Bereichen 3a, 3b mit gegenüber den beiden nachfolgend beschriebenen Ätzmitteln resistentem Fotolack (3a, 3b) überzogen, in denen die Siliziumoxidnitridschichten erhalten bleiben sollen (Figur 2). An den von Fotolack freien Bereichen 4a, 4b wird z. B. mittels gepufferter Flußsäure, d. h. einer Mischung von Flußsäure HF und Ammoniumfluorid $NH_4F$ die Siliziumoxidnitridschicht weggeätzt (Figur 3). Die Siliziumschicht 1 des Trägermaterials wird hierdurch nicht oder nur sehr wenig angegriffen. Anschließend wird, z. B. mittels einer wässerigen Kalilauge (KOH Lösung in Wasser), gegen die Siliziumoxidnitrid gut resistent ist, in den Bereichen 4a, 4b, in denen die Siliziumoxidnitridschicht entfernt worden war, das Silizium der Trägerschicht 1 weggeätzt (Figur 4).

Es entsteht somit ein Biegebalken B aus Siliziumoxidnitrid, der mit dem stehengebliebenen Trägermaterial T aus Silizium verbunden ist und an seinem Ende eine Masse M aus Silizium trägt, die bei Beschleunigungen oder Verzögerungen des Sensors den Biegebalken B mehr oder weniger verbiegt (Figur 5). Auf ähnliche Weise kann eine Membran hergestellt werden. Hierzu wird die Schicht 2a nicht strukturiert, so daß die Fläche 4a erhalten bleibt. Bei einer Membran mit verstärkter Mitte ist die Fläche 3b erforderlich, die Masse M stellt dann die Verstärkung dar. Bei einer reinen Membran entfällt die Fläche 3b, so daß der Bereich M gleich mit weggeätzt wird.

Die Herstellung einer aus Siliziumoxidnitrid bestehenden oder dieses Material enthaltenden Dünnschicht gemäß der Erfindung bietet den Vorteil, daß eine schwierig zu handhabende Ethylendiamin-Brenzkatechin-Wasser-Lösung nicht benötigt wird und daß Standardhalbleiterprozesse in LPCVD-Anlagen oder in PEGVD-Anlagen wegen der entfallenden Dotierungen durchgeführt werden können. Außerdem können die Siliziumoxidnitridschichten in ihrem Wärmeausdehnungsverhalten der Trägerschicht (z. B. Silizium) angepaßt werden, so daß sie weitgehend spannungsfrei sind oder eine gewünschte Vorspannung haben. Die Schichtdicke kann relativ genau hergestellt werden, weil definierte Ätzstopps vorliegen, die nicht zeitabhängig sind.

Auf der Siliziumoxidnitridschicht 2a kann nun eine Metallbeschichtung z. B. in Form eines Metallwiderstandes (Leiterbahn) aufgebracht werden (Figur 6), die bei Biegung der Unterlage aus Siliziumoxidnitrid ebenfalls mit gebogen wird. Die Metallschicht wird im elastischen Bereich gelängt und erhöht dadurch ihren Widerstand. Derartige Widerstandsänderungen lassen sich in bekannter Weise erfassen, z. B. in empfindlichen Brückenschaltungen. Aus ihnen kann dann auf die auslösenden mechanischen Kräfte geschlossen werden. Geeignete Metallwiderstände weisen abweichend von Halbleiterwiderständen mit ihren großen Temperaturkoeffizienten, beschränkten Temperaturmeßbereichen und großen Fertigungsstreuungen bezüglich der vorgenannten Werte sehr vorteilhafte Eigenschaften auf. Ein Nickelchromwiderstand hat z. B. einen sehr geringen Temperaturkoeffizienten und erlaubt eine Messung in einem großen Temperaturbereich. Er kann mit kleiner Fertigungsstreuung hergestellt werden, hat aber einen relativ kleinen elektrischen Widerstand, so daß die Länge der Leiterbahn groß gewählt werden muß, was z. B. in Form einer Mäanderstruktur im Bereich der Biegung seiner Unterlage aus Siliziumoxidnitrid geschehen kann. Solche flächenmäßig aufwendigen Strukturen lassen sich nur schwer auf nach bekannten Verfahren hergestellten Biegebalken oder Membranen aufbringen, jedoch relativ einfach auf Dünnschichten, die gemäß der Erfindung hergestellt sind.

Mit 7 bezeichnete Leiterbahnen, z. B. aus Nickelchrommaterial, lassen sich vorteilhaft durch ein sogenanntes Sputterverfahren aufbringen. Sputteranlagen sind der vorerwähnten Broschüre "Technologie-Trends in der Sensorik" auf Seiten 182 bis 184 zu entnehmen. Dabei werden durch Kathodenzerstäubung (Sputtern) bei Unterdruck in einer in Inertgas (Argon)-Atmosphäre Metallteilchen, z. B. aus Nickelchrom, aus einer entsprechenden Metallschicht von aufprallenden ionisierten Gasatomen, die durch eine angelegte Spannung in einem Plasma gebildet werden, gelöst. Diese Teilchen fliegen zu der Siliziumoxidnitridschicht 2a, an der sie fest anhaften und eine Metallschicht bilden. Nach Aufbringen von Fotolack (nicht dargestellt) an den Stellen, an denen die Leiterbahn 7 gebildet werden soll, wird das überflüssige Metall in bekannter Weise weggeätzt, so daß nur noch die Leiterbahn übrigbleibt. Es können auch mehrere Widerstände (z. B. zwei Widerstände, nicht dargestellt) aufgebracht werden, deren elektrische Widerstandswerte durch Verbiegen der Siliziumoxidnitridschicht 2a beeinflußt wird. Außerdem kann ein oder mehrere passive Widerstände 7a (nur einer angedeutet) aufgebracht werden, um z. B. eine elektrische Brückenschaltung zur Erfassung der Widerstandsänderungen bei Verbiegung der Siliziumoxidnitridschicht 2a realisieren zu können.

Nach Kontaktieren der Leiterbahn beispielsweise mit Nickelkontakten (lötbar) und eventuellem Vorschalten von temperaturempfindlichen Widerständen zur Kompensation der Temperaturdrift (bei Nickelchrom z. B. aus Nickel) ist der aktive Teil des Sensors oder Aktuators fertiggestellt, der nunmehr in ein geeignetes Gehäuse eingesetzt werden kann. Die Siliziumoxidnitridschicht kann mit einer entsprechenden metallischen Beschichtung auch als Biegebalken oder Membran in kapazitiv arbeitenden Sensoren oder Aktuatoren eingesetzt werden.

Beispiele zur Herstellung von Schichten aus Siliziumoxidnitrid (SiON).

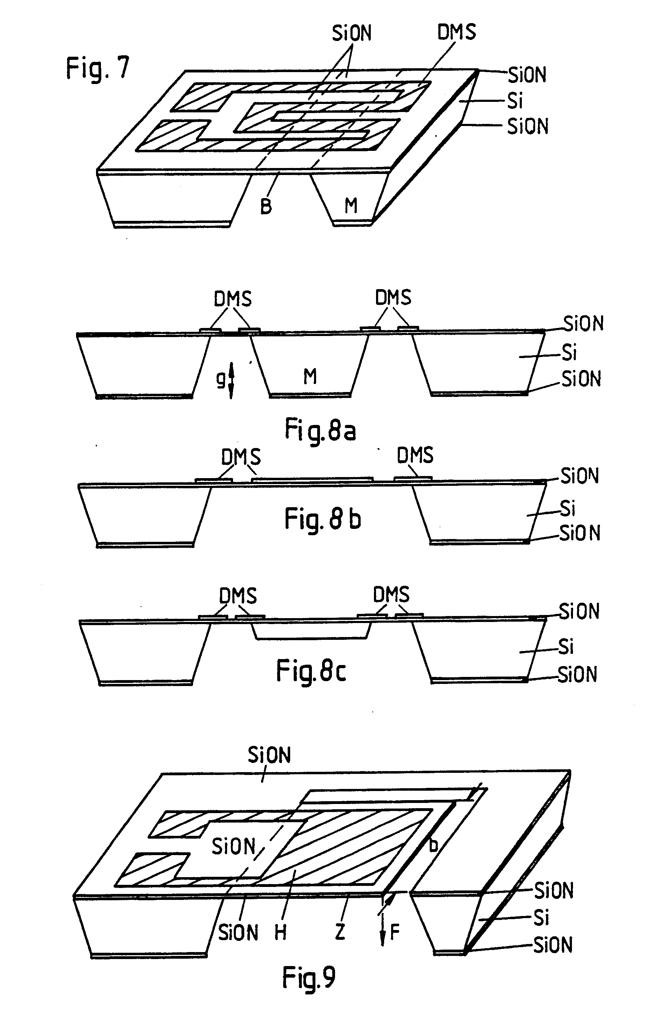

1. Beispiel zur Herstellung einer SiON-Schicht für Beschleunigungssensoren mit einseitig befestigten Biegebalken (Fig. 7).

Um den Vorteil von Metalldehnungsmeßstreifen (DMS) aus NiCr (kleiner Temperaturkoeffizient und großer Temperatureinsatzbereich), deren Widerstandsänderungen bei Verbiegungen unter dem Einfluß von Beschleunigungskräften g zur Bildung von Meßsignalen dient, zu nutzen, benötigt man große Flächen eines isolierenden Materials (SiON). Dieses Material soll den gleichen Wärmeausdehnungskoeffeizienten wie das Trägermaterial (Si) haben, damit beim Ätzen des Siliziums von der Unterseite am Ende des Ätzvorgangs kein "Bimetalleffekt" auftritt und die SiON-Schicht nicht zerstört wird.

Der Metalldehnungsmeßstreifen soll so dünn wie möglich sein, um die mechanischen Eigenschaften des Biegebalkens B nicht nennenswert zu verändern. Bei einer Dicke des DMS von $0,1\mu m$ ergeben sich gute elektrische wie mechanische Eigenschaften. Die SiON-Schicht wird $2\mu m$ dick hergestellt. Dies ist ein Kompromiß zwischen einer möglichst großen Schichtdicke und einer nicht zu langen Herstellungsdauer. Die Empfindlichkeit des Sensors wird durch die Geometrie (Länge des Biebebalkens und Größe der Masse M festgelegt) . Mit g sind die Richtungen der Beschleunigungskraft bezeichnet.

Mit M ist die aus Silizium bestehende Masse bezeichnet, die den Biegebalken bei Beschleunigungen und Verzögerungen mehr oder weniger verbiegt.

Herstellungsparameter einer (gegenüber Silizium möglichst spannungsfreien) SiON-Schicht.

1.1 LPCVD-Verfahren
Prozeßtemperatur: 900 °C
Prozeßdruck: $3 \times 10^{-1}$ Pa
Prozeßgase:
Dichlorsilan SiH2CL2 = 20 ml/min
Ammoniak NH3 = 300 ml/min
Sauerstoff $O_2$ = 10 ml/min
Pumpsystem:
Rootspumpe der deutschen Firma Leybold, Hanau, vom Typ WS151 (Saugvermögen $153m^3/h$)
Drehschieberpumpe LH/D16BC (Saugvermögen $16m^3/h$)
Prozeßrohr: Quarzrohr 120 mm Durchmesser
Prozeßdauer: 2h für $2\mu m$ Schichtdicke
Die SiON-Schicht ist bei einem Brechungsindex von n = 1,65 spannungsfrei.

1.2 PECVD-Verfahren
Anlage: Typ z401 der deutschen Firma Leybold, Hanau
Prozeßtemperatur: 350 °C
Prozeßdruck: $3 \times 10^1$ Pa
Prozeßgase:
(2% SiH4 in N2) = 150 ml/min
$O_2$ = 0,8 ml/min
Plasma:
Hochfrequenzgenerator 13,56 MHz
Hochfrequenzleistung 100W
Prozeßdauer: 2h für $2\mu m$ Schichtdicke
Die SiON-Schicht ist bei einem Brechungsindex von n = 1,69 spannungsfrei.

Wegen der niedrigeren Temperatur wird die Schicht lockerer und läßt sich dadurch leichter strukturieren. Durch die prozeßbedingten Gaseinschlüsse erhält man andere mechanische Eigenschaften. Ist dieses weichere Material nicht erwünscht, so muß eine Temperung in geeigneter Atmosphäre erfolgen.

2. Beispiel zur Herstellung einer SiON-Schicht für Drucksensoren (Membran) und zweiseitig eingespannten Beschleunigungssensoren (Fig. 8a. . .8c).

Fig. 8a: Beschleunigungssensor (zweiseitig eingespannt)
Fig. 8b: Drucksensor
Fig. 8c: Drucksensor mit mittenversteifter Membran

Bei diesen Bauformen soll die auf dem Trägermaterial aus Silizium aufgebrachte SiON-Schicht nicht unter Druckspannungen stehen, weil es sonst zu einer Aufwölbung kommen kann. Bedingt durch die Fertigungstoleranzen wird also eine SiON-Schicht mit kleiner Zugspannung benötigt. Dazu wird der Sauerstoffanteil leicht verringert. Mit DMS sind Metall-Dehnungsmeßstreifen (z.B. aus NiCr) bezeichnet, deren Widerstandsänderungen bei Verbiegungen unter dem Einfluß von Beschleunigungskräften g zur Bildung von Meßsignalen genutzt werden. Mit M ist eine sogenannte Beschleunigungsmasse bezeichnet.

2.1 LPCVD-Verfahren

Prozeßparameter wie bei Beispiel 1.1. Nur O2 ist verändert.

$O_2$ = 6 ml/min

Der Brechungsindex ist dann n = 1.7

2.2 PECVD-Verfahren

Prozeßparameter wie im Beispiel 1.2. Nur O2 ist verändert.

$O_2$ = 0.4 ml/min

Der Brechungsindex ist dann n = 1.76

3. Beispiel zur Herstellung einer SiON-Schicht für ein Stellglied (Aktuator) (Fig. 9).

Da die Schichtdicke der SiON-Schicht nicht beliebig verstärkt werden kann, können größere Kräfte nur aufgebracht werden, wenn die Breite "b" vergrößert wird. Mit spannungsfreiem SiON (hergestellt wie in Beispiel 1 beschrieben) lassen sich solche Stellglieder herstellen.

Wirkungsweise:

Erwärmt man durch Strom die Metallschicht H auf der freitragenden Fläche des SiON, so verformt sich das Bimetall der Zunge Z und die Kraft "F" steht zur Verfügung.

**Ansprüche**

1. Dünnschichtmaterial für Sensoren oder Aktuatoren auf Siliziumbasis, dadurch gekennzeichnet, daß das Material Siliziumoxidnitrid ist.

2. Dünnschichtmaterial nach Anspruch 1, dadurch gekennzeichnet, daß eine Siliziumoxidnitridschicht (2a) als Material für ein biegsames Element (B) eines Sensors oder Aktuators vorgesehen ist.

3. Dünnschichtmaterial nach Anspruch 1 und/oder 2, dadurch gekennzeichnet, daß das Mengenverhältnis der die Siliziumoxidnitridschicht bildenden Bestandteile Siliziumoxid (Si $O_2$) und Siliziumnitrid (Si$_3$ N$_4$) so eingestellt wird, daß in der Siliziumoxidnitridschicht möglichst keine oder eine gewünschte Vorspannung auftritt.

4. Dünnschichtmaterial nach einem oder mehreren der vorhergehenden Ansprüche, dadurch gekennzeichnet, daß das Mengenverhältnis der die Siliziumoxidnitridschicht (2a, 2b) bildenden Bestandteile Siliziumoxid (Si $O_2$) und Siliziumnitrid (Si$_3$ N$_4$) der Trägermaterialschicht (1) im Sinne eines zumindest annähernd gleichen Wärmeausdehnungsverhaltens angepaßt ist.

5. Dünnschichtmaterial nach einem oder mehreren der vorhergehenden Ansprüche, dadurch gekennzeichnet, daß das biegsame Element als Membran oder Biegebalken (B) ausgebildet ist.

6. Dünnschichtmaterial nach einem oder mehreren der vorher gehenden Ansprüche, gekennzeichnet durch eine Meßanordnung zur Erfassung der Verbiegung des Elementes (B).

7. Dünnschichtmaterial nach Anspruch 6, gekennzeichnet durch eine elektrische Meßanordnung (7, 7a) zur Erfassung der Verbiegung des Elementes.

8. Dünnschichtmaterial nach Anspruch 7, gekennzeichnet durch eine elektrische Meßanordnung, bei der der Widerstand eines elektrischen Leiters, insbesondere eines aus Nickel-Chrom-Material bestehenden Leiters, durch die Verbiegung des Elementes beeinflußt wird.

9. Dünnschichtmaterial nach einem oder mehreren der vorhergehenden Ansprüche, dadurch gekennzeichnet, daß die aus Siliziumoxidnitrid bestehende Schicht (2a) Teil einer Metall-Dehnungsmeßstreifenanordnung zur Umwandlung einer mechanischen Größe (Kraft, Druck, Beschleunigung) in eine elektrische Größe ist.

10. Dünnschichtmaterial nach einem oder mehreren der Ansprüche 1 bis 8, dadurch gekennzeichnet, daß die aus Siliziumoxidnitrid bestehende Schicht Teil einer kapazitiven Meßanordnung zur Umwandlung einer mechanischen Größe (Kraft, Druck, Beschleunigung) in eine elektrische Größe ist.

11. Verfahren zum Herstellen von Dünnschichtmaterial für Sensoren oder Aktuatoren auf Siliziumbasis, dadurch gekennzeichnet, daß eine Siliziumoxidnitridschicht auf eine Trägermaterialschicht aufgebracht wird und daß danach das Trägermaterial in bestimmten Bereichen entfernt wird.

12. Verfahren nach Anspruch 11, dadurch gekennzeichnet, daß die Siliziumoxidnitridschicht auf die Trägermaterialschicht, vorzugsweise Silizium, in einer LPCVD-Anlage aus Gasen, die durch Wärme aktiviert und Silizium, Stickstoff und Sauerstoff abgeben, abgeschieden wird.

13. Verfahren nach Anspruch 11, dadurch gekennzeichnet, daß die Siliziumoxidnitridschicht auf die erwärmte Trägermaterialschicht, vorzugsweise Silizium, in einer PECVD-Anlage aus Gasen, die durch ein Plasma aktiviert werden und Silizium, Stickstoff und Sauerstoff abgeben, abgeschieden wird.

14. Verfahren nach Anspruch 12 oder 13, dadurch gekennzeichnet, daß das Silizium aus gasförmigem Silan ($Si_n H_{2n+2}$, insbesondere $Si H_4$), Dichlorsilan ($Si H_2 Cl_2$) oder Tetraethylorthosilikat, der Stickstoff aus Ammoniak ($NH_3$) und der Sauerstoff aus Sauerstoffgas ($O_2$) abgeschieden wird.

15. Verfahren nach Anspruch 14, dadurch gekennzeichnet, daß die Siliziumoxidnitridschicht in einer LPCVD-Anlage bei Temperaturen zwischen 800 °C und 1200 °C, bevorzugt zwischen 850 °C und 950 °C, und einem Druck zwischen $5 \times 10^0$ und $8 \times 10^1$ Pascal, bevorzugt zwischen $2 \times 10^{-1}$ und $5 \times 10^{-1}$ Pascal, abgeschieden wird.

16. Verfahren nach Anspruch 15, dadurch gekennzeichnet, daß die Siliziumoxidnidtridschicht bei einer Temperatur von ca. 900 °C und einem Druck von ca. $3 \times 10^{-1}$ Pascal aus erhitztem mit 20 ml/min an der Trägermaterialschicht vorbeiströmendem Dichlorsilangas, aus mit ca. 300 ml/min vorbeiströmendem Ammoniakgas und aus mit ca. 10 ml/min vorbeiströmendem Sauerstoffgas ($O_2$) abgeschieden wird.

17. Verfahren nach einem oder mehreren der Ansprüche 11 bis 16, dadurch gekennzeichnet, daß das Mengenverhältnis der die Siliziumoxidnitridschicht bildenden Verbindungen Siliziumoxid ($Si O_2$) und Siliziumnitrid ($Si_3 N_4$) bei der Bildung der Schicht einstellbar ist.

18. Verfahren nach Anspruch 17, dadurch gekennzeichnet, daß das Mengenverhältnis so eingestellt wird, daß die Siliziumoxidnitridschicht eine gewünschte mechanische Spannung aufweist oder zumindest annähernd spannungsfrei ist.

19. Verfahren nach Anspruch 17 und/oder 18, dadurch gekennzeichnet, daß das Mengenverhältnis so eingestellt wird, daß die Siliziumoxidnitridschicht zumindest annähernd das gleiche Wärmeausdehnungsverhalten aufweist wie die Trägermaterialschicht.

20. Verfahren nach einem oder mehreren der Ansprüche 11 bis 19, dadurch gekennzeichnet, daß zum Freilegen der Siliziumoxidnitridschicht (2a) die auf der Trägermaterialschicht (1) gegenüberliegende Siliziumoxidnitridschicht (2b) in den Bereichen (3b), in denen die Trägermaterialschicht entfernt werden soll, mittels einer geeigneten Ätzlösung oder Ätzplasma, z. B. mittels eines Gemisches von Flußsäure (HF) und Ammoniumfluorid ($NH_4 F$) entfernt wird, wonach in diesen Bereichen die Trägermaterialschicht (z. B. Silizium) mittels einer geeigneten Ätzlösung, z. B. mittels einer wässerigen Kalilauge (KOH in Wasser gelöst) entfernt wird.

21. Verfahren nach einem oder mehreren der Ansprüche 11 bis 20, dadurch gekennzeichnet, daß die Siliziumoxidnitridschicht (2a) mittels Kathodenzerstäubung (Sputtern) metallisiert wird.

22. Verfahren nach Anspruch 21, dadurch gekennzeichnet, daß zum Bilden von Leiterbahnen (7a, 7b), vorzugsweise aus Nickelchrommaterial, deren Widerstandsänderungen bei Biegung der Siliziumoxidnitridschicht unter der Einwirkung einer Kraft als Meßwert für die zu messende die Biegung verursachende Kraft erfaßt wird, die überflüssige Metalloberfläche durch eine Ätzlösung entfernt wird.

Fig. 1

Fig. 2

Fig. 3

Fig. 4

Fig. 5

Fig. 6

EP 0 381 046 A2

Fig. 7

Fig. 8a

Fig. 8 b

Fig. 8c

Fig. 9